# EUROPEAN PATENT SPECIFICATION

(11) **EP 1 893 526 B1**
(45) Date of publication and mention of the grant of the patent: **18.10.2017**
(21) Application number: 06743536.2
(22) Date of filing: 30.05.2006
(51) Int. Cl.: B81C 1/00

(54) **THINNING OF A SI WAFER FOR MEMS-SENSORS APPLICATIONS.**
VERDÜNNUNG EINES SI-WAFERS FÜR ANWENDUNGEN ALS MEMS-SENSOREN
AMINCISSEMENT D'UN WAFER DE SI POUR DES APPLICATIONS DANS LES CAPTEURS MEMS

(30) Priority: 02.06.2005 US 143191
(43) Date of publication of application: 05.03.2008
(73) Proprietor: OKMETIC OYJ, 01510 Vantaa (FI)
(72) Inventor: LEMPINEN, Vesa-Pekka, 04300 Tuusula (FI); MÄKINEN, Jari, 02710 Espoo (FI); TILLI, Markku, 02760 Espoo (FI)
(74) Representative: Berggren Oy, Helsinki & Oulu
(86) International application number: PCT/FI2006/000168
(87) International publication number: WO 2006/128953

(56) References cited:
- EP-A1- 0 444 943
- EP-A2- 0 476 897
- EP-A2- 0 561 532
- WO-A2-2005/017972
- JP-A- 5 226 674
- JP-A- 10 256 568
- US-A1- 2002 187 595
- US-B1- 6 388 279
- HARENDT C ET AL: "Wafer bonding: investigation and in situ observation of the bond process" SENSORS AND ACTUATORS A (PHYSICAL) SWITZERLAND, vol. A23, no. 1-3, April 1990 (1990-04), pages 927-930, XP002401045 ISSN: 0924-4247
- ERGUN A S ET AL: "Capacitive micromachined ultrasonic transducer technology for medical ultrasound imaging" PROGR. BIOMED. OPT. IMAGING PROC. SPIE; PROGRESS IN BIOMEDICAL OPTICS AND IMAGING - PROCEEDINGS OF SPIE; MEDICAL IMAGING 2005 - ULTRASONIC IMAGING AND SIGNAL PROCESSING 2005, vol. 5750, 15 February 2005 (2005-02-15), pages 58-68, XP002401046
- SUNI T ET AL: "SOI wafers with buried cavities" PROC. ELECTROCHEM. SOC.; PROCEEDINGS - ELECTROCHEMICAL SOCIETY; SEMICONDUCTOR WAFER BONDING VIII: SCIENCE, TECHNOLOGY AND APPLICATIONS PROCEEDINGS OF THE INTERNATIONAL SYMPOSIUM 2005, vol. PV 2005-02, 16 May 2005 (2005-05-16), - 20 May 2005 (2005-05-20) pages 216-225, XP008069459
- SCHMIDT M A: "Silicon wafer bonding for micromechanical devices" TECHNICAL DIGEST. SOLID-STATE SENSOR AND ACTUATOR WORKSHOP TRANSDUCER RES. FOUND CLEVELAND HEIGHTS, OH, USA, 1994, pages 127-131, XP008069462 ISBN: 0-9640024-0-X
- PETERSEN K ET AL: "Fabrication of SOI wafers with buried cavities using silicon fusion bonding and electrochemical etchback" SENSORS AND ACTUATORS A, ELSEVIER SEQUOIA S.A., LAUSANNE, CH, vol. 54, no. 1-3, June 1996 (1996-06), pages 709-713, XP004077953 ISSN: 0924-4247
- ANONYMOUS: "Silicon Wafer" INTERNET ARTICLE, [Online] 2004, XP002401047 Retrieved from the Internet: URL:http://www.semiwafer.com/products/sili con.htm> [retrieved on 2006-09-28]
- Andrzej Prochaska ET AL: "<title>Production of silicon diaphragms by precision grinding</title>", Proceedings of SPIE, vol. 4174, 25 August 2000 (2000-08-25), pages 244-255, XP55134690, ISSN: 0277-786X, DOI: 10.1117/12.396440

## Description

### FIELD OF THE INVENTION

In a very general level, the invention relates to manufacturing of thin silicon comprising structures. More particularly, the invention relates to a method of thinning silicon comprising structures, such as for instance wafers, to a predetermined thickness according to the preamble of an independent method claim of thinning silicon comprising structures. The invention relates also to a structure comprising silicon according to the preamble of an independent claim presented for the structure comprising silicon. The invention also relates to a sensor comprising silicon-comprising structure according to the preamble of an independent claim claiming such a sensor. The invention also relates to an electronic device comprising a sensor according to the preamble of an independent claim claiming such an electronic device. The invention relates also to a mechanical device comprising a sensor according to the preamble of an independent claim claiming such a mechanical device.

### BACKGROUND

In manufacturing of silicon structures according to the known techniques, layered structures can be made with silicon substrate in many different ways as a skilled person in the art knows from the known techniques. Such layers can be of several substances, comprising silicon oxide or nitride, for instance. On certain substrates, relating to sensor manufacturing, for instance, cavities can be formed locally in to the silicon substrate surface to a certain deepness by chemical etching or by other techniques, e.g. by reactive ion plasma etching.

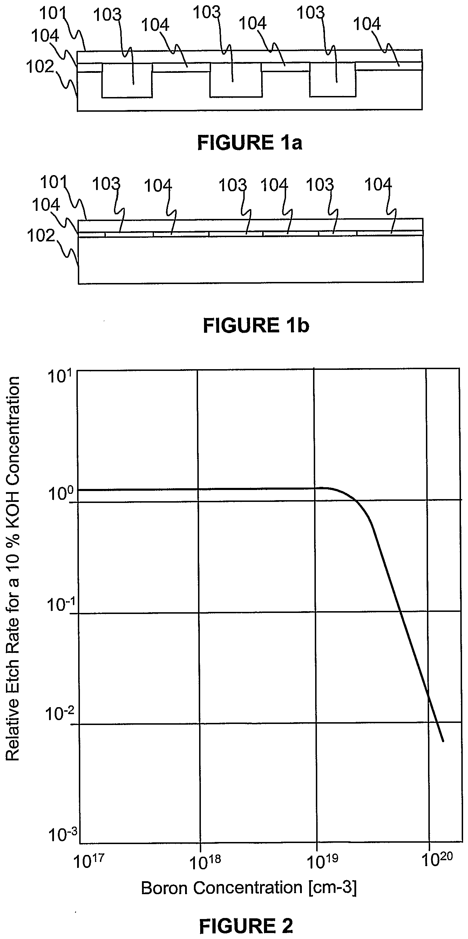

Many sensor manufacturing processes utilize structures, where a thin silicon membrane is bonded on top of a recess or cavity of a silicon wafer. The schematics of the resulting intermediate structure are illustrated in Figures 1a and 1b. In Figure 1 a the cavity 103 is through a silicon dioxide 104 layer and penetrating in to the silicon 102, and 1b the cavity 103 is trough the silicon dioxide layer 104 only.

In these structures, between the silicon part 102, and a membrane 101, there may be a silicon dioxide layer 104, but many variations exist and it is also possible that there is no silicon dioxide layer there between at all, or, all cavity surfaces are covered with silicon dioxide layer. It is also possible to have another layer like silicon nitride between the silicon wafers.

This kind of structure, where membrane is on top of the cavity, as either sealed or without sealing, can be used as such as an intermediate step to produce e.g. pressure sensors (sealed cavity e.g. in connection with an absolute pressure sensor), or as an intermediate step to produce structure, where membrane is structured, e.g. from membrane is made cantilevers which are hanging over the cavity.

The described structures can be made e.g. in known techniques in several ways, for instance by i) Etch stop structures, ii) Technology based on SOI (silicon on insulator wafer), iii) Technology based on grinding and polishing. However, utilization of the EPI- and/or SOI-based technology needs several phases of manufacturing for the wafer as preceding the thinning procedure, i.e. the wafer has been designated to a certain composition and/or structure quite far in the processing before the final thinning, which, however, may be technically very demanding and crucial for the product quality and thus has an influence on the yield of the process and consequently to the price of the product utilizing the structure. In some sophisticated methods, a film layer of the wafer needs to be transferred to another surface, which is shortly explained in the following in i) and ii).

Publication "Wafer Bonding: Investigation and in situ Observation of the Bond Process" by Hardent et al in Sensor and Actuators, A21-A23 (1990) pp 927-930 as well as the article "Capacitive Micromachined Ultrasonic Transducer Technology for Medical Ultrasound Imaging" by Ergun et al. in Proc. of SPIE Vol 5750, pp 58-68 disclose techniques of layer transfer techniques as said therein, at its closest to a corresponding part in the preamble of independent method claim.

Other known solutions are represented by publications of Ergun et al. (Capacitive micromachined ultrasonic technology for medical ultrasound imaging), Suni et al. (SOI wafers with buried cavities), Schmidt (Silicon wafer bonding for micromechanical devices), Petersen et al. (Fabrication of SOI wafers with buried cavities using silicon fusion bonding and electromechanical etchback), and Prochaska et al. (Production of silicon diaphragms by precision grinding), patent US 6,388,279 B1, patent applications JP 5-226674 A and JP 10-256568 A, and PCT publication WO 2005/017972 A2.

### i) Technology using etch stop structures

Technology based on etch stop layer is a well known techniques with wafers composing of a specially dedicated wafer structure for various purposes. In such techniques heavily boron doped area or layer effectively slows down etch speed of silicon when using potassium hydroxide-water mixture as etchant. Depending on doping density the etch speed can be only 1% of the etch speed of non-doped silicon when using e.g. 24% KOH-water mixture at 60 °C (for 10 % KOH in Figure 2, Seidel H., Csepregi I., Heuberger A. and Baumgärtel, H., J. Electrochem. Soc., 137 (1990) 3612) [1].

Utilization of this phenomenon facilitates a possibility to make a structure for example having a cavity and a membrane sealing that cavity as in the following paragraph:
a) Cavity structure is made on a handle wafer.
b) On a top of the handle wafer a second wafer is bonded, which second wafer, which is an epi-wafer having heavily boron doped thin layer for etch stop purpose and on top of that epi-layer there is a second lightly doped epi-layer. The bonding is done in such a way that the lightly doped epi layer is facing towards cavities.
c) The bonded epi-wafer is thinned down to the heavily boron doped layer e.g. first by grinding the lightly doped handle wafer partially away, and then continuing with the remaining by chemically etching with above mentioned potassium hydroxide etchant mixture. It is also possible to use only chemical etching without the grinding.
d) The remaining heavily boron doped epi-layer can be etched away with a suitable etch.

The remaining structure is a handle wafer with cavities sealed with a controlled membrane. This structure can be then processed further.

### ii) Technology based on SOI (Silicon On Insulator wafer)

Sealed cavity structure can be made alternatively to i) by using SOI-wafers utilizing the buried silicon dioxide layer etch stop features and the process in the following example:
a) Cavity structure is made on a handle wafer,
b) An SOI wafer is bonded on the handle wafer the thin active layer facing towards the handle wafer and its cavity structure.
c) The handle wafer of the SOI wafer is removed partially to a thickness e.g. by grinding which is followed with etching with such an etchant, which has good selectivity concerning silicon and silicon dioxide or with a plasma process which has similar property. The oxide layer of the SOI-wafer stops the etching effectively.
d) The oxide is removed where necessary. The structure can be addressed into further processing.

### iii) Technology based on grinding and polishing

The sealed cavity structure can be made alternatively to the i) and /or ii) by bonding a polished wafer on top of a wafer having cavities as follows:
a) Cavity structure is made on a handle wafer
b) A polished wafer is bonded on top of the wafer with cavities
c) The bonded wafer is thinned e.g. by grinding and then polishing to final thickness.

The remaining structure is a handle wafer with cavities sealed with a thin membrane and ready for further processing. The membrane may have a structure with thickness, which is actually quite large originating to the thickness non-uniformities and the elastic properties of the membrane. Nevertheless, the structure can be used for further processing.

Although there are existing technologies as such to make such structures as described above in i)-iii), a viable process has several requirements for making structures where a membrane is on top of a cavity. Examples of the difficulties these requirements meet are described below for the known processes.
- The properties of the structure are sensitive to the membrane thickness and the control thereof, as well as to the thickness variation of the membrane above cavity.
- The membrane surface is exposed during the critical steps of the processes. The membrane has to remain intact during wet chemical treatments to prevent exposure of the cavity to the chemicals and to avoid damaging or contaminating the inside of the cavity.
- The bond quality outside cavities between wafers is sensitive to various aspects of the process, but should be good.
- Such production processes may have many drawbacks as demonstrated above, which reflect directly in the yield of the process and the cost efficiency.

When analyzing various known techniques discussed in i) -iii), following conclusions can be made:
i) Wafer having build in etch stop feature as heavily doped etch stop epi-wafer is costly wafer, especially for mass production. Wafer having a heavily doped epi-layer as an etch stop feature may have surface defects which may reduce bond quality and decrease process yield. Wafer having a heavily doped epi-layer as an etch stop feature may require different etchant mixtures to remove heavily doped and lightly doped silicon, increasing complexity of the process as well as the potential risk for injuring the membrane or other part of the structure during the steps.
ii) SOI wafer is costly and thus the overall production cost is increasing.
iii) Conventional process forming the membrane by grinding and polishing to final thickness has for example following drawbacks:
   If the final membrane thickness is too thin in respect to the lateral dimensions of the cavity, mechanical forces break the membrane over the cavity allowing process chemicals to penetrate into the cavity. Because of that, the whole bonded wafer assembly may be unusable. In a case where wafer sites have only broken cavities, membrane breakage causes yield losses. Also if the final membrane is too thin in respect to the lateral dimensions of the cavity, mechanical forces bend the membrane resulting in variation of the membrane thickness above the cavity. Limitations because of the elasticity of the membrane material are met easily with quite large remaining material thicknesses of the membrane.

The membrane, after a known manufacturing process, if too thin, may in extreme case remain as having a non-uniform thickness on the cavity structure having a rather unpredictable appearance possibly varying from cavity to another, but, having larger thickness at the cavity than beside the cavity. Additionally, such membrane can suffer from other undesirable non-uniformities, which limit the utilizability of the membrane with in the cavity structures.

The demand of miniaturization of the component size towards the smaller and smaller structures cannot be maintained economically tolerable level for large series of mass production with the structures of the described known processes for the cavity structures.

### SUMMARY OF THE INVENTION

It is an object of the invention to solve the problems of the known techniques or at least mitigate the influence of the problems to the final product. The object is achieved by the embodied invention.

A great advantage of the invention is that for mass production, rather expensive EPI and/or SOI-wafers are not needed for the wafer to start with. Instead of such expensive one, a more economic, simple silicon wafer can be used. The membrane can be directly on the silicon wafer before the thinning. Also the yield of the process can be higher as in a process of EPI or SOI process with layer transference, but also better products in large scale can be manufactured according to the embodiments of the invention.

A method of thinning silicon-comprising structures according to the invention is characterized in that what has been indicated in independent method claim 1. Other preferred embodiments of the invention are shown in the dependent claims. Term "to comprise" has been used in the open meaning. The shown embodiments of the invention are only examples of the various embodiments and are not as such limiting the invention. Embodiments of the invention can be combined in suitable part.

According to an embodiment of the invention the method of thinning silicon comprising structures to a predetermined thickness comprises phases of:
- a first thinning phase for thinning the surface to be thinned to a first thickness in preparatory manner;
- a second thinning phase for thinning said surface to be thinned finally to a second thickness.

According to an embodiment of the invention the silicon comprising structure comprises at least one wafer comprising silicon.

According to an embodiment of the invention, said first thinning phase can comprise a phase of grinding, polishing and/or etching, but said second thinning phase comprises a phase of etching. According to an embodiment of the invention, at least one of said phase of etching comprises etching by using an etchant mixture, which comprises an alkaline solution for etching silicon. According to an embodiment of the invention, said alkaline solution can comprise sodium hydroxide, potassium hydroxide, TMAH (tetramethylammonium hydroxide), and/or EDP (ethylenediamine-pyrocatehol-pyrazine-water-mixture) as solution constituents. A skilled person in the art knows from the shown embodiments of invention, that the solution can be mixed from such solutions that contain said constituents. However, the solution as such is not limited by the solvent, which can comprise other substances than said water. Such solution can comprise in an embodiment of the invention additional substances, for instance such as IPA (iso propyl alcohol).

In a further embodiment of the invention, the alkaline solution can be also impregnated to a certain concentration with a gas, for example with oxygen. The concentration of the gas depends on the solubility of the gas into the solution in the temperature and pressure. Some oxygen, for instance, can be solved into the solution. The gas as solved and/or as bubbled can be used for removal of impurities and/or certain reaction products from the solution. For instance, hydrogen can be thus reduced. Also other gases can be used for bubbling.

According to an embodiment of the invention, the second phase of thinning is made with a solution that comprise at least one of the solution constituents in liquid form. The solution can be formed even without or with very low concentration of water. Even pure constituents in the liquid form as etchant can be used according to an ensemble of alternative embodiments.

According to an embodiment of the invention, a thinning phase comprises etching, which comprises at least one of the following, performed alone or in any suitable combination: wet etching, alkaline etching, plasma etching and spin etching. The spin etching can be performed, according to an embodiment of the invention, with a mixture with an alkaline composition, but according to an alternative embodiment with an acidic composition. According to a further embodiment of the invention alkaline and acidic mixture can be used in an alternating way each in turn.

According to an embodiment of the invention, the silicon structure comprising silicon to be thinned comprises silicon in the part of said structure to be thinned, wherein said silicon comprises {100}, {110} and/or {111} -oriented phases. The silicon to be thinned can be in {100}, {110}, {111} -orientation or tilted from said orientations or in other low index orientation (depicted by indexes hkl, where h,k,or I can be up to 5, in any combination, or tilted from said low index orientations). Silicon comprising structure to be thinned should be understood so that, the remaining part of the structure to be thinned, for instance the membrane that was left after the removal of silicon comprising layers, can comprise silicon. Alternatively the remaining part can be composed of non-silicon substances, provided that the removed layers by thinning comprise silicon.

According to an embodiment of the invention the final thickness, into which the remaining membrane structure is to be thinned, for a sealing purpose of the cavity with a membrane layer at the opposite side of the cavity as the cavity bottom, is essentially not dependent on the elasticity of said membrane structure. According to an embodiment of the invention said membrane can be used for sealing a structure that has at least one cavity, with such a membrane that has a uniform final thickness, which is essentially or exactly the same as the final thickness outside said cavity. Alternatively, the remaining membrane can be thinned according to an embodiment of the invention to a certain non-zero predetermined thickness gradient across the sealed structure with cavities. According to an embodiment of the invention said structure comprises a uniform final thickness, which can be a thickness of a membrane, thickness at the bottom of the cavity, or a substrate thickness outside a cavity, or a bare substrate thickness. According to an alternative embodiment of the invention, the cavity structure containing handle wafer with the membrane can be thinned from the outer side of the bottom of the cavity containing handle wafer. According to an embodiment of the invention, the membrane and/or handle wafer can be thinned. According to an embodiment of the invention, the membrane can have cavities irrespective the fact has the handle wafer embodied with cavities or, in another embodiment variation, without cavities.

According to an embodiment of the invention a sensor element can be implemented with a structure comprising silicon according to an embodiment of the invention, as thinned to a certain thickness according to any embodiment of the invention. Such structure comprises a uniform final thickness at the thinned locations on the structure surface to be used for the sensor. However, in case of cavities present, the thickness (in the direction of thinning) of the handle wafer is different at the cavities than outside/beside the cavities, when considering the handle wafer alone. The membrane can be made to a uniform thickness in the structure.

As an alternative to a uniform final thickness, also the thickness can have gradient thickness, i.e. the layer thickness, residing after the final thinning of said layer, can be changing in a continuous manner from a first final thickness at first location on the wafer to a second final thickness at second location on the wafer, provided that said first and second final thicknesses have a different value, at least between said first and second location.

According to an embodiment of the invention a sensor according to an embodiment can be comprised in an electronic device and /or in a mechanic device for sensing a quantity of which the sensor is addressed to sense, such as for instance pressure, which can be sensed with a silicon comprised structure with cavities, having a silicon comprised structure thinned to a final thickness according to an embodiment of the invention. The device can have also mechanic and electric features so constituting an electro-mechanical device according to an embodiment of the invention, but according to a further embodiment of the invention, as scaled down even to a nano size.

Because the Figures 1 a and 1b as well as Figure 2 were used for referring to features of known techniques so that
- Figure 1a: illustrated a cavity trough a silicon dioxide layer, penetrating in to the silicon,
- Figure 1b: illustrated a cavity trough the silicon dioxide layer only, and
- Figure 2: illustrated a relative etch rate as a function of boron concentration in a known techniques,
the following figures are used referring to the exemplary embodiments of the invention, wherein :
- Figure 3: illustrate a method according to an embodiment of the invention,
- Figure 4: illustrate a structure comprising silicon as thinned according to an embodiment of the invention,
- Figure 5: illustrate a sensor according to an embodiment of the invention,
- Figure 6: illustrate a device using sensor according to an embodiment of Figure 5, and
- Figure 7: illustrate a further detailed example of the method according to an embodiment of the invention

### DETAILED DESCRIPTION OF PREFERRED EMBODIMENTS

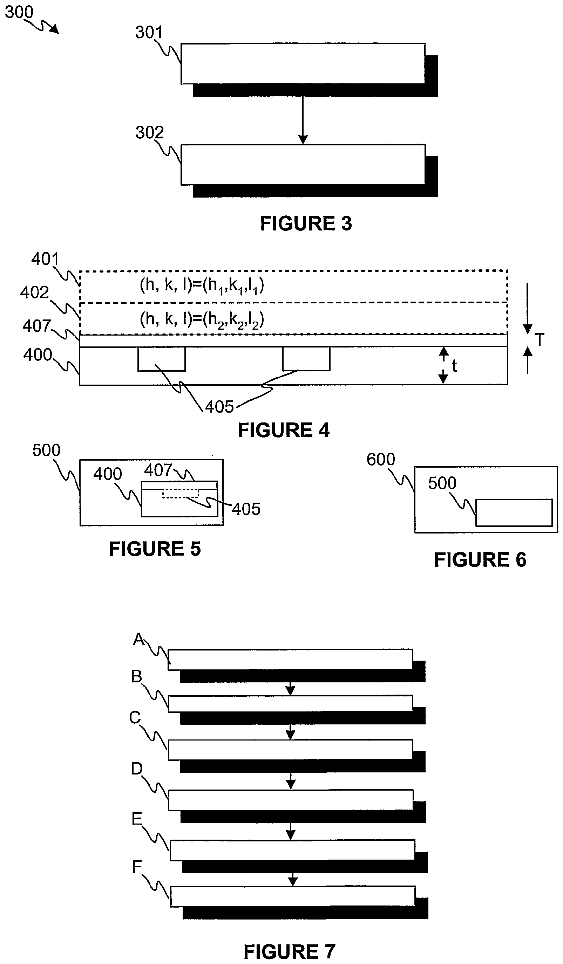

Figure 3 illustrates a method according to an embodiment of the invention. It is assumed that the structure comprising silicon is exemplary embodied in the following as a wafer, but without any attention to exclude any embodiments of the invention. The structure comprising silicon can be, but is not limited to, also a wafer that has the membrane at a surface to be attached to the handle wafer with the cavities.

A method 300 of thinning a wafer having to a predetermined thickness comprises in very general level two phases 301, 302. First phase 301 is a preparatory thinning phase, which comprises polishing for a rapid thinning to a certain pre-phase of the wafer. Polishing can be a separate phase although it is in the embodiment included in to the first phase 301 in the shown embodiment of Figure 3. The material is removed to a safe thickness in respect of elasticity of the material being thinned in the preparatory phase. The first phase can comprise several sub-phases, from which at least one comprises thinning phase. In the example of Figure 3 the second phase of thinning is the final thinning phase 302, which can be made by etching to a certain predetermined second thickness or in an alternative embodiment to a thickness gradient.

In Figure 4, a bonded wafer as non-thinned comprise layers 401, 402, 407, which has been illustrated as bonded to a handle wafer 400 having a cavity 405 structure. In an exemplary embodiment, the cavities 405 can have a dimension into an oxide and/or nitride layer (not shown) of the handle wafer 400 only, but in another embodiment the cavities 405 can be optionally formed to have a dimension into the silicon structure of the handle wafer. The handle wafer can be a normal silicon wafer only or essentially composed of silicon, but it can additionally comprise also oxide and/or nitride layer on the surface. The situation in Figure 4 is depicted to illustrate the assembly at the beginning of the thinning process 300. The layer comprising layers 401 and 402, the layers of the bonded wafer, the layers to be removed by a preparatory thinning phase 301 and final thinning phase 302, respectively, can be essentially mutually similar to each other or differently structured. The lattice structure of the layers is demonstrated by the hkl-indexes indicating the layer structure. Although the layer 401 has depicted with different indexes h1, k1, l1 as the layer 402 with the indexes h2, k2, l2, the layers can be also the same but the mentioned layers are not limited to those of Figure 4. The layers 401, and 402 can be removed in the example of Figure 4 by the thinning method 300 in the phases 301 and 302 of thinning, respectively. The preparatory phase 301 can remove layer 401 depicted by indexes h1, k1, l1 and the final thickness in phase 302 can remove layer 402 depicted by indexes h2, k2, l2.

Skilled person in the field understands from the embodied examples of the invention, that the number of thinning phases can be even larger than two so that the phase can be a preparatory phase for a next phase, in series of thinning phases and consequently such serial thinning falls into the scope of the embodied invention. Also skilled person understand from the invention that the method 300 can be used once, but also more than once repeatedly for thinning of layers of the bonded wafer and/or the layers of the handle wafer.

The final minimum thickness T for the membrane 407 is independent on the elasticity of the material of the layer 407. The desired geometric properties (the thickness as the whole thickness T+t, where t is the desired thickness of the handle wafer 400) of the structure are achieved after the final thinning phases applied to bonded wafer, the membrane and/or the handle wafer.

Because of the gentle process according to the embodiment of the invention the thickness achievable by the method 300 is a thinner thickness gained more reliably and with lower expenses than a thickness of the known art with traditional thinning methods according to the knowledge of the applicant at the priority date of this application. The thickness can be made very thin according to the embodiment of the invention and the same time more uniform result can be achieved.

The fine thinning phase 302, can be made in several ways, but according to the embodiment of the invention, by etching. The etching is made preferably by an alkaline solution comprising the etchant in the mixture. Thus the solution can comprise sodium hydroxide, potassium hydroxide, TMAH (tetramethylammonium hydroxide) and/or EDP (ethylenediamine-pyrocatechol-pyrazine-water mixture).

In addition, according to an embodiment of the invention, the etching of the fine thinning phase can comprise at least one of the following performed alone or in any combination: alkaline etching, plasma etching and spin etching. In an embodiment of the invention, especially the spin etching can be performed in combination with an alkaline etchant.

The etching can be made in an alternative embodiment of the invention by an etchant having an acidic etchant composition.

The desired etching speed of the alkaline solution as well as the alkalinity of the solution and/or the concentration can be selected to correspond to the wafer composition in a chemical sense, but also in the sense of the lattice structure. In a preferred embodiment of the invention, as shown in Figure 4 those parts, layer 402 of the wafer that are to be thinned away by the fine thinning phase 302 of the method 300 are arranged in the wafer manufacturing phases to comprise such silicon which has {100}, {110} and/or {111} -oriented surface phases. In the silicon to be thinned, there can be in addition or alternatively to {100}, {110}, {111} orientation or tilted from said orientations or in other low index orientation (depicted by indexes hkl, where h,k,or l can be up to 5 in any possible combination), or tilted from said low index orientations in the lattice (indexed as h,k,l in Figure 4).

Several layers each having different indexes as such are possible, but may increase the manufacturing costs of the wafer comprising the membrane for the handle wafer in the final product of the thinning process 300. According to an embodiment of the invention the etchant is selected according to the lattice structure. According to an embodiment of the invention the fine etching method is selected in more detail according to the material of the lattice structure in the layer to be etched. According to an embodiment of the invention the alkaline properties of the fine etchant are selected according to the material of the lattice structure.

According to an embodiment of the invention the second thinning phase is made in a low temperature, up to 100 °C. The exact temperature is selected according to the etchant, the etching rate, the material to be etched and the desired final thickness for the second thinning phase. According to an embodiment of the invention, the second thinning phase can be made alternatively in high-temperature conditions, wherein the temperature is below 500 °C, advantageously below 280°C, but most advantageously below 150 °C. The pressure in the second thinning phase is preferably essentially ambient pressure or even a lower pressure than ambient pressure. When using plasma etching in the second thinning phase in an embodiment of the invention, the pressure can be set to typical level of the plasma etching and so even to near vacuum conditions for the duration of the plasma etching. According to an alternative embodiment of the invention, the second thinning phase and/or first thinning phase can be made under high-pressure conditions, wherein the pressure is below 30 bars. Advantageously the pressure is below 20 bars, but even more advantageously below 10 bars but most advantageously below 5 bars, provided that the handle wafer structures as well as the membrane are sufficiently strong to tolerate such conditions in the final thickness.

The suitable pressure and/or temperature conditions are selected for an expected uniformity of the final thickness. The selection is based on a certain etchant composition for a particular etching rate to gain uniform final thickness. The temperature and/or the pressure conditions influence on the etching and the rate, which can be controlled with temperature and/or pressure to a certain extent.

The wafer comprising layers 401, 402, 407 can comprise the layers 401 and 402 to be thinned away, which is demonstrated with the dashed line. The border between the layers 401 and 402 is demonstrated with the dashed line, because of the layers can be made of same substance, but are thinned away with a different phase (301, 302) of the method 300. The layer 401 can be optimized in an embodiment of the invention so that the layer 402 can be etched in predetermined manner aiming to the remaining membrane 407 as having a uniform thickness after applying the process 300, or alternatively a desired thickness gradient according to an embodiment of the invention.

Although according to an embodiment of the invention as shown in the Figure 4, there has not been drawn any layers between layers 400 and 407, a skilled person in the art knows, that according to another embodiment of the invention there can be an intermediate layer, but in a further variant of such an embodiment, also several layers. In an embodiment, such layers can originate to the handle wafer and/or to the membrane originating to the wafer bonded. Composition of such a layer can comprise oxygen and/or nitrogen for example, according to the corresponding specific embodiment, according to the planned use for a structure in an inertial sensor, for example. However, the number, presence or composition of individual layers in each embodiment as such is not limited by the embodiment shown in Figure 4 as an example.

The handle wafer 400 can comprise the cavities 405 as indicated in the Figure 4 but is not limited to the number of cavities shown in the example. Beside the cavity 405, the thickness t of the handle wafer outside of the cavity 405 and/or beside the cavity 405 can be different than that T of the membrane. According to an embodiment of the invention, cavities can be made into a membrane. Such a membrane with the cavities can be closed with another membrane. According to a further embodiment of the invention such a further membrane can comprise cavities, but is not necessary limited to that.

The thinning in two-phase as in the embodied method in Figure 3 yield thinner structures (t, T Figure 4) with no or very few limitations from the elasticity of the membrane material to be used, and said structure has fewer defects more reliably and/or in a lower cost than the earlier methods according to the known techniques.

Thus the utilization of the wafers, thinned by a method 300 according to an embodiment of the invention, a sensitive sensor 500 according to Figure 5 can be gained with a low-loss process and/or economically effective way. The fine structure of the sensor has not been shown for simplicity in Figure 5, but a skilled person in the art knows from the embodied invention what kind of a fine structure such sensor can have for the applications in known devices using a sensor for the addressed sensing. A membrane 407 and optionally a cavity 405 (indicated by the dashed line) have been illustrated as an example in Figure 5. According to an embodiment, a sensor in question can be a sensor for sensing inertia, and/or pressure. From the application text a skilled person in the art knows that also such sensors that can sense quantity values for quantity dependent on inertia and/or pressure can be implemented according to the embodiment of inertial and/or pressure sensors. Such sensors 500, for pressure metering applications can be used in electro-mechanical devices 600 for the sensing duties of the devices 600 (Figure 6). Especially, in an embodiment of the invention where either type of the mentioned device 600, mechanical or electrical, has its expected major course of operation, the device can be of macroscopic size in which the sensor is utilized for the sensing duties of the device, but according to an other embodiment of the invention the device can be also a micro-mechanical device. Micro-mechanical is considered to cover solely mechanical devices as well as solely electronic devices but also devices there between all in micro scale irrespective of the course of the dominant operation in the axis mechanical-electric. Downwards scaling even from the micro mechanical scale has no limitation to the specific embodiments of the invention, except the features dictated by the wafer material itself and/or the practical etching speed of the alkaline solution. So, even nano-scaled devices according to an embodiment of the invention can be thus provided with suitable sensors according to an embodiment of the invention. As an example of very simple device, it is possible, by the structure comprising silicon according to an embodiment of the invention, to make a pressure sensor and/or to provide a switch with said pressure sensor for a pressure sensitive switching operation. The operation can be used also for a temperature sensitive switching in conditions, where the relation between the temperature and pressure are available, exactly or as a reasonable estimate. The switch can be a macroscopic, micromechanical, a nano-switch or an ensemble of the mentioned, provided that part of the switches can be semiconductor switches.

The handle wafer as such as well as the bonded wafer as such are assumed to be manufactured according to a known process as such to the level of preceding the preparation phases A) and B).

According to an embodiment of the invention, the method of thinning can be understood via the example of a process as follows:
A) Cavity structure is made on a handle wafer, wafer can be polished, have silicon dioxide layer on top of it or some other suitable layer, such as a thin film for instance.
B) A polished wafer is bonded on top of the wafer with cavities. This wafer can have also thin films on top if desired.
C) The bonded wafer is thinned mechanically e.g. by grinding and then polishing on to a thickness independently on the elasticity of the membrane over the cavity and not causing non-even thickness variation and membranes are uniform enough
D) After the intermediate thinning, thinning is continued further by etching the membrane thinner with suitable etchant mixture attacking selected crystal orientation uniformly. These kind of etchant mixtures are e.g. alkaline solutions, like sodium hydroxide, potassium hydroxide water mixtures, or mixtures containing TMAH (tetramethylammonium hydroxide) and/or EDP working at higher than room temperatures. Alternatively etching can be made with a solution that comprises only very little water or with a solution containing essentially no water at all. With careful process control it is possible to etch (100) oriented silicon wafers in such a way that the surface roughening is not too extensive. It is also possible to etch other low index atomic planes similarly, so that for example (110) or (111) oriented surfaces can be etched.
E) It is possible to adjust thickness of the membrane in a very controlled way by adjusting the etch time when etch speed is known. This kind of thickness adjustment offers more precise and repeatable method to control uniformity of the membrane thickness over the cavity than methods of basing mechanical thinning and polishing.
F) If required, a final or touch polish can be made to further smoothen the surface, if bondability of the etched surface or some other reason requires such a procedure.

The phases A and B are having a preparatory nature for the next phases. In the phase C) the preparatory thinning phase with a polish has been performed. The final thinning is made in the phase D) for a specific exemplary embodiment. In phase E the etching speed is adjusted and the phase F indicates an ending of the thinning process according to an embodiment of the invention. The remaining structure is a handle wafer with cavities sealed with a thin membrane and ready for further processing.

According to an embodiment of the invention the fine etching in step D can be performed alternatively by different techniques in many ways. According to an embodiment of the invention plasma etching is used for the etching. According to another embodiment of the invention, a wet etching process can be used. The wet etching can be embodied as an immersion and/or spin etching process, in which also alkaline solutions are used in one embodiment, but acidic solutions in another embodiment. The etchings as such can be applied in suitable part to the preparatory etchings, in addition or alternatively to the mechanical thinning.

The alkaline etching embodied can be replaced totally or in suitable part by plasma etching or spin etching by spraying or otherwise delivering suitable etchant on rotating wafer surface.

In an alternative embodiment of the invention the process phases in phase C can be replaced also with fine grinding producing smooth enough surface with uniform damage layer or without damage layer for further processing, or some other method producing mechanical force on the wafer.

According to an embodiment of the invention, a handle wafer with cavities can be used as a first handle wafer, and a second wafer with cavities can be used as a bonded wafer, to be positioned so that said handle wafer and bonded wafer are facing each other at the cavity openings. According to a variant of such embodiment there is a membrane between said wafers as thinned to a final thickness, at least on one cavity. Manufacturing of such a combined wafer structure with cavities can comprise steps of a thinning method according to an embodiment of the invention. The thinning can be made for at least one of the wafers separately and/or after the combining of the wafers.

According to an embodiment of the invention the thinning can be made in several parts. The number of thinning phases can thus be larger than two, but a thinning phase made earlier acts as a preparatory phase to next phase in a method according to an embodiment of the invention. Therefore, the actual number of thinning phases is not limited to two, although exemplary were embodied with a two-phase example. Therefore the final thickness can be even thinner than second thickness after the second thinning phase, especially when there is a third thinning phase that has the second thinning phase as a preparatory phase.

## Claims

1. A method (300) of thinning silicon comprising structures to a predetermined thickness (T) for providing a wafer structure (400, 407) comprising:
a bonding phase for bonding a simple silicon wafer (401, 402, 407) on a top surface of a handle wafer (400), the silicon in the simple silicon wafer having at least one of (h00), (hk0), or (hkl) -oriented phases as straight or tilted from said oriented phases, or in other low index orientation, wherein indexes h, k, l can be up to 5 and the top surface of the handle wafer (400) defining at least one cavity (405),
a first thinning phase (301) for thinning the simple silicon wafer bonded to the top surface of the handle wafer by polishing, and
a second thinning phase (302) for thinning the polished simple silicon wafer (402, 407) bonded to the top surface of the handle wafer by etching so that the polished and then etched simple silicon wafer (407) defines a membrane (407) that covers the top surface of the handle wafer, comprising the cavity (405), the membrane having a uniform membrane thickness (T) above the top surface of the handle wafer, wherein the second thinning phase comprises etching by using an etchant mixture comprising an alkaline solution for etching silicon.

2. The method according to claim 1, wherein said alkaline solution comprises sodium hydroxide, potassium hydroxide and/or tetramethylammonium hydroxide TMAH and/or ethylenediamine-pyrocatechol-pyrazine EDP.

3. The method according to claim 1, wherein the second thinning phase is made in high-pressure conditions.

4. The method according to claim 1, wherein the second thinning phase is made in high-temperature conditions.

5. The method according to claim 1, wherein the membrane thickness is independent of an elasticity of the silicon forming the membrane.

6. The method according to claim 1, wherein the silicon comprises at least one of (100), (110), and (111) -oriented phase.

## Patentansprüche

1. Verfahren (300) des Dünnens von Silizium umfassenden Strukturen auf eine vorbestimmte Dicke (T) zum Bereitstellen einer Waferstruktur (400, 407), umfassend:
eine Bondphase zum Bonden eines einfachen Siliziumwafers (401, 402, 407) auf einer oberen Oberfläche eines Handle-Wafers (400), wobei das Silizium in dem einfachen Siliziumwafer mindestens eine von (h00) -, (hk0) - oder (hkl) - orientierten Phasen als gerade oder geneigt von den orientierten Phasen, oder in anderer Orientierung mit niedrigem Index, aufweisen, wobei die Indizes h, k, 1 bis zu 5 betragen können und die obere Oberfläche des Handle-Wafers (400) mindestens einen Hohlraum (405) definiert,
eine erste Dünnungsphase (301) zum Dünnen des auf die obere Oberfläche des Handle-Wafers gebondeten einfachen Siliziumwafers durch Polieren, und
eine zweite Dünnungsphase (302) zum Dünnen des auf die obere Oberfläche des Handle-Wafers gebondeten polierten einfachen Siliziumwafers (402, 407) durch Ätzen, so dass der polierte und dann geätzte einfache Siliziumwafer (407) eine Membran (407) definiert, die die obere Oberfläche des Handle-Wafers bedeckt, umfassend den Hohlraum (405), wobei die Membran eine gleichförmige Membrandicke (T) über der oberen Oberfläche des Handle-Wafers aufweist, wobei die zweite Dünnungsphase das Ätzen unter Verwendung einer eine alkalische Lösung umfassenden Ätzmittelmischung zum Ätzen von Silizium umfasst.

2. Verfahren nach Anspruch 1, wobei die alkalische Lösung Natriumhydroxid, Kaliumhydroxid und/oder Tetramethylammoniumhydroxid TMAH und/oder Ethylendiamin-pyrokatechol-pyrazin (EDP) umfasst.

3. Verfahren nach Anspruch 1, wobei die zweite Dünnungsphase unter Hochdruckbedingungen durchgeführt wird.

4. Verfahren nach Anspruch 1, wobei die zweite Dünnungsphase unter Hochtemperaturbedingungen durchgeführt wird.

5. Verfahren nach Anspruch 1, wobei die Membrandicke von einer Elastizität des die Membran bildenden Siliziums unabhängig ist.

6. Verfahren nach Anspruch 1, wobei das Silizium eine (100)- und/oder (110)- und/oder (111)- orientierte Phase umfasst.

## Revendications

1. Procédé (300) consistant à amincir des structures comprenant du silicium jusqu'à une épaisseur prédéterminée (T) pour obtenir une structure de tranche (400, 407) comprenant :
une phase de liaison destinée à lier une simple tranche de silicium (401, 402, 407) sur une surface supérieure d'une tranche de manipulation (400), le silicium dans la simple tranche de silicium ayant au moins une des phases orientées (h00), (hk0) ou (hkl) droite ou inclinée par rapport auxdites phases orientées, ou dans une autre orientation de faible indice, les indices h, k, 1 pouvant aller jusqu'à 5, et la surface supérieure de la tranche de manipulation (400) définissant au moins une cavité (405),
une première phase d'amincissement (301) destinée à amincir la simple tranche de silicium liée à la surface supérieure de la tranche de manipulation par polissage, et
une deuxième phase d'amincissement (302) destinée à amincir la simple tranche de silicium polie (402, 407) liée à la surface supérieure de la tranche de manipulation par gravure de telle sorte que la simple tranche de silicium polie puis gravée (407) définisse une membrane (407) qui recouvre la surface supérieure de la tranche de manipulation, comprenant la cavité (405),
la membrane ayant une épaisseur de membrane uniforme (T) au-dessus de la surface supérieure de la tranche de manipulation, la deuxième phase d'amincissement comprenant une gravure au moyen d'un mélange d'agents de gravure comprenant une solution alcaline pour graver le silicium.

2. Procédé selon la revendication 1, dans lequel ladite solution alcaline comprend de l'hydroxyde de sodium, de l'hydroxyde de potassium et/ou de l'hydroxyde de tétraméthylammonium TMAH et/ou de l'éthylènediamine-pyrocatéchol-pyrazine EDP.

3. Procédé selon la revendication 1, dans lequel la deuxième phase d'amincissement est réalisée dans des conditions de haute pression.

4. Procédé selon la revendication 1, dans lequel la deuxième phase d'amincissement est réalisée dans des conditions de haute température.

5. Procédé selon la revendication 1, dans lequel l'épaisseur de membrane est indépendante d'une élasticité du silicium formant la membrane.

6. Procédé selon la revendication 1, dans lequel le silicium comprend au moins une des phases orientées (100), (110) et (111).
